# EUROPEAN PATENT APPLICATION

(11) **EP 0 982 732 A1**
(43) Date of publication of application: **01.03.2000**
(21) Application number: 99116520.0
(22) Date of filing: 24.08.1999
(51) Int. Cl.: G11C 7/00

(54) **Portable MP3 player having various functions**

(30) Priority: 24.08.1998 KR 9834267
(71) Applicant: Saehan Information Systems Inc., Seoul, 121-710 (KR)
(72) Inventor: Hahm, Yeong Ook, Saehan Building 254-8, Seoul 121-710 (KR)
(74) Representative: Dr. Weitzel & Partner

(57) **Abstract**

An MP3 player and its data providing system are disclosed. A voice from a microphone is convened into a digital audio signal by an A/D converter. An MP3 music file and private information such as phone numbers or memos are downloaded from a data providing apparatus such as a computer through an interface to the MP3 player. A CODEC decodes the MP3 music file for reproduction, encodes the digital audio signal into a voice data file by PCM or an ADPCM method, and decodes the encoded voice data file. A D/A converter converts the decoded digital audio signal into an analog audio signal for the reproduction of voice or music. The MP3 player uses an nonvolatile memory for storing the encoded voice data file or the downloaded files from the computer. The MP3 player has a key pad comprising various function keys with which a user can direct an operation of the MP3 player, which is controlled by a microcomputer. The files stored in the MP3 player can be also uploaded to the computer. Furthermore, the MP3 player has various additional functions.

## Description

### Background of the Invention

### 1. Field of the Invention

The present invention relates to an apparatus for recording and reproducing digital data and more particularly to a MP3 player, having basic functions for downloading, storing and reproducing digital files from a data providing apparatus such as a computer or a data vending machine and further having additional functions.

### 2. Description of the Prior Art

A typical MP3 file is obtained by compression-coding audio data in a format of MPEG1 LAYER3. Generally, this MP3 format is widely used for making a computer music file, but nowadays news or lecture is also realized through the MP3 format.

As MP3 files are intrinsically oriented for a computer environment, it was able to be reproduced only by a computer system with a multimedia function until a dedicated audio reproducing apparatus was known. Conventionally, without the use of a multimedia computer system, various methods of reproducing MP3 file are being used. For a cassette tape player, MP3 music files are first converted to analog type audio signals in a computer system, and then the analog signals are recorded on a cassette tape. Another way is to use a compact disc (CD) player. For this, MP3 tiles are copied on a CD disk.

However, these methods are disadvantageous in that when MP3 files are recorded on the recording medium such as the above cassette tapes or CD disks, data errors may be appear on the recorded data from the recoding medium, which may result in a deteriorated quality of sound during the reproduction.

### Summary of the Invention

Therefore, it is a first object of the present invention to provide an MP3 player having a function of downloading MP3 music files and various additional information such as phone numbers or memos from an external data providing apparatus reproducing them if necessary.

It is a second object of the present invention to provide an MP3 player having functions of recording voice data in a form of a digital data file after signal processing and reproducing or transmitting the recorded voice file to an external apparatus if necessary.

It is a third object of the present invention to provide an MP3 player having function of displaying all kinds of languages, so far as they can be supported by the data providing apparatus, on its display panel.

In order to accomplish the above objects, there is provided a method of recording and reproducing a digital data as a first aspect of the invention, comprising the steps of: a) executing a management program of a data providing apparatus for integrally managing both the data providing apparatus and a MP3 player; b) selecting a file to be downloaded to the MP3 player from files stored in the data providing apparatus in a running state of the management program; c) storing the downloaded file in a nonvolatile memory of the MP3 player; d) recording a voice signal from a microphone in a form of a digital voice file in the nonvolatile memory; e) selecting a file to be reproduced from the files stored in the nonvolatile memory; and f) reproducing the selected file into an audio output by decoding the selected file.

The voice signal which is an analog signal is at first converted into a digital voice data, then is encoded in either a pulse coded modulation (PCM) method or an adaptive differential pulse coded modulation (ADPCM) method, and finally recorded in a form of a voice file in the nonvolatile memory of the MP3 player. The recorded voice file can be reproduced into the original voice through a decoding process in the same method, if necessary.

The MP3 music file includes a music data and an additional data. The latter is convened into a bit-map format form prior to being downloaded and is displayed on a display panel of the MP3 player upon the reproduction of the MP3 music file.

The files stored in the nonvolatile memory can be uploaded to the data providing apparatus, if necessary. Besides, phone numbers or memos inputted with the data providing apparatus also can be downloaded to the MP3 player and then can be displayed on the display panel of the MP3 player.

As a second aspect of the present invention, there is provided a portable data recording/reproducing MP3 player apparatus. The MP3 player includes an analog-to-digital converting means for convening an analog audio signal of a voice provided by a microphone into a digital audio signal; a coding/decoding means for decoding an MP3 music file in an MP3 decoding method, encoding the digital audio signal into a voice data file in a predetermined decoding method, and decoding the voice data file by the predetermined decoding method; an interfacing means for interfacing a reception and a transmission of a data file between an external data providing apparatus and the MP3 player; a nonvolatile memory means for storing the encoded voice data file from the coding/decoding means and the data file from the data providing means at a designated address; a key input means, including a plurality of function selection keys, for selecting a file to be reproduced into an audio signal from the nonvolatile memory and for directing a predetermined function with the function selection keys; a digital-to-analog converting means for convening a digital audio signal decoded by the coding/decoding means into an analog audio signal for an audio reproduction; and a control means, in response to an output signal of the key input means, for controlling a data communication between the data providing apparatus and the data recording/reproducing apparatus, reading and writing operations to the nonvolatile memory and a reproduction of a read-out file. A computer system or a data vending machine can be utilized as the data vending machine.

As a third aspect of the present invention, there is provided a system for recording and reproducing a digital data comprising: a computer, including an MP3 file management program, for performing download and upload of any kinds of computer files besides an MP3 music file and a recorded voice file through a parallel port; and an MP3 player for reproducing the MP3 music file while displaying information related to the MP3 music file, for recording a voice signal originated from a microphone in a form of a digital voice file in a nonvolatile memory and reproducing the digital voice file if necessary, and for displaying information of phone numbers and memos, in response to user's key operations, wherein the MP3 player is connected to the computer through the parallel port, the MP3 music file and the information of the phone numbers and memos are downloaded from the computer to be stored in the nonvolatile memory.

According to the present invention, the MP3 player has a voice recording function and additional functions for saving and displaying character data such as phone numbers and memos except the basic function for storing and reproducing of the MP3 music file. That is, with the MP3 player, a user can easily record a voice at any time or place, and reproduce the recorded voice file if necessary. Furthermore, the user can upload the recorded voice file to computer and can preform the reproduction and management of the voice file. As such, the MP3 player works as another input/output apparatus of the computer and has a more convenient function when it is cooperated with the computer.

Meanwhile, the MP3 player does not need a recording medium such as a cassette tape for a cassette tape player or a CD for a CD player as a data source. Thus, there is no need for the MP3 player to have a driving mechanism of the recording medium. This allows a simple configuration of the MP3 player and a good quality of the output signal even when an impact is applied to the MP3 player.

Furthermore, the MP3 player does not require to have a large size font ROM and can support various languages because the character data are downloaded in the form of a bit-map from the computer, which results in a lower manufacturing cost.

### Brief Description of the Drawings

The above objects and other advantages of the present invention will become more apparent by describing in detail a preferred embodiment thereof with reference to the attached drawings, in which:
FIG. 1 shows a configuration of a digital data recording and reproducing system according to the present invention;
FIGs. 2 to 5 shows screen views of a computer monitor displayed by an execution of a management program according to the present invention;
FIG. 6 shows an external appearance of a portable MP3 player according to the present invention;
FIG. 7 illustrates a mapping format of a flash memory of the portable MP3 player;
FIG. 8 explains various operation modes of the portable MP3 player;
FIGs. 9 to 16 shows various hierarchy views of every operation mode in a liquid crystal display (LCD) panel of the MP3 player.

### Description of the Preferred Embodiment

An embodiment of the present invention will hereinafter be described in detail with reference to the drawings.

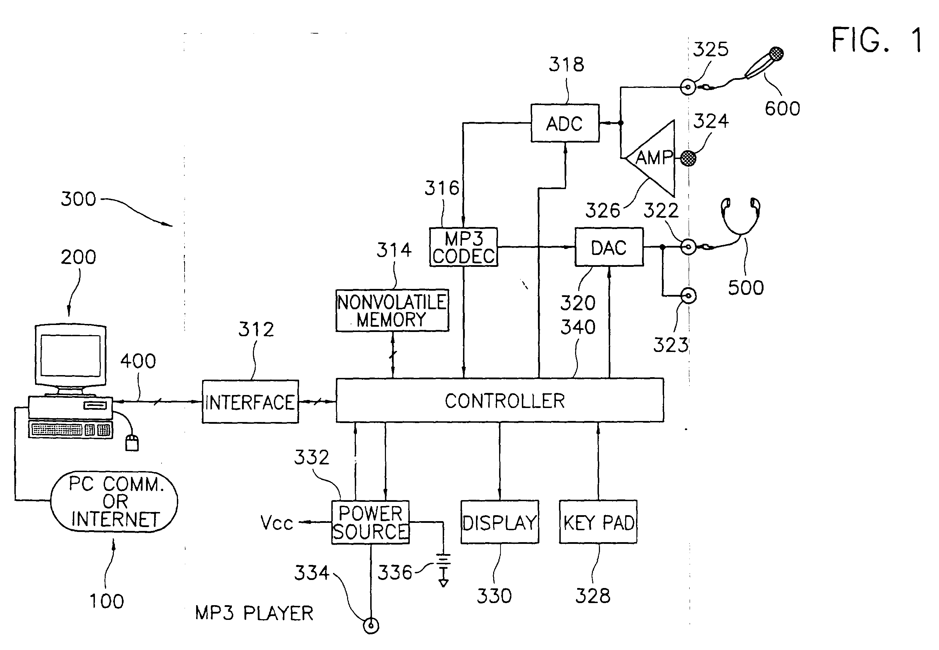

Referring to FIG. 1, a configuration of a digital data recording/reproducing system according to the present is illustrated. The system includes broadly a computer 200 and an MP3 player 300. Here, computer 200 should be understood as an example of an external data providing apparatus. A commercially available data vending system, which has ever been commercialized nowadays, can works as the external data providing apparatus if it has a management program which makes the system work as designed functions according to the present invention.

Computer 200 is required that it should have an operating system which can support a graphic user interface, for example, Window series operating system of Microsoft Co. Ltd., and a communication environment which can support a data communication with an external source through a communication network, like a conventional personal computer. A management program for an integral file management between MP3 player and computer 200 is installed in computer 200. By means of the management program, some files such as various kinds of the MP3 music files which was downloaded to computer 200 through Internet or a computer communication network 100 or computer files stored in a hard disc of computer 200 can be downloaded to MP3 player 300, and reversely some files stored in MP3 player 300 can be uploaded to computer 200.

Computer 200 and MP3 player 300 are connected with each other by a communication cable 400 for a data communication. In detail, one end of communication cable 400 is connected to a parallel port of computer 200 and the other end is connected to a communication port of MP3 player 300.

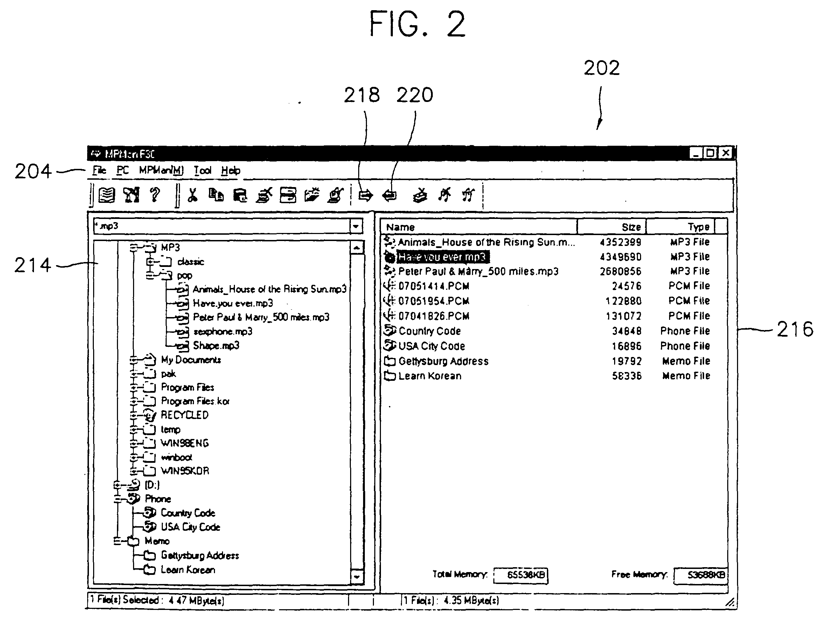

FIG. 2 shows a main menu 202 of the management program displayed on a monitor of computer 200 when the management program is running after an installation of the management program.

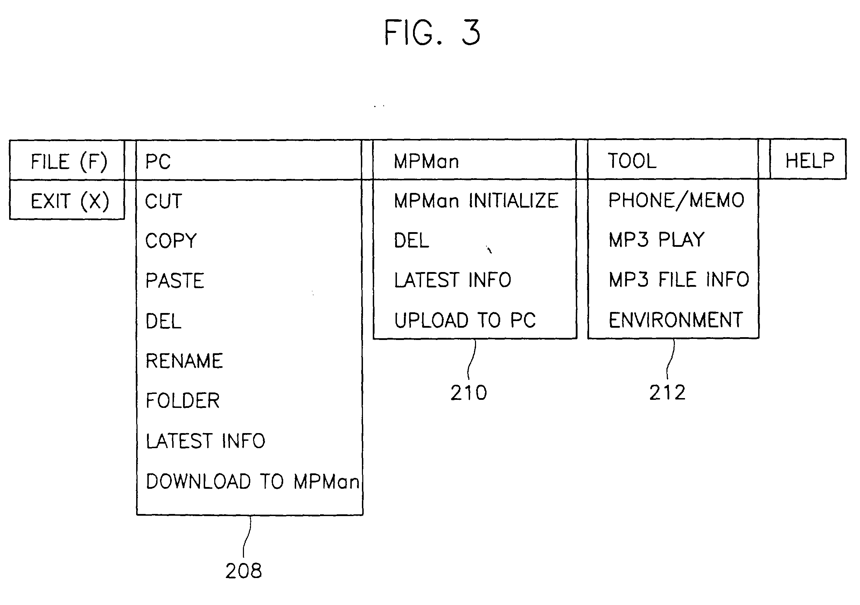

In main menu 202, there is provided with a menu section 204 having some menus named "File, PC, MPMan, Tool and Help". Here, the MPMan is a trademark of the MP3 player of the applicant. As shown in FIG. 3, the File menu includes "Exit" menu, and the PC menu includes some submenus of "Cut, Copy, Paste, Delete, Rename, Folder, Latest Information, and Download to MPMan" in its dropdown menu box 208. The MPMan menu includes "MPMan Initialize, Delete, Latest Information, and Upload to PC" in its dropdown menu box 210. There are also provided with some submenus of The Tool menu such as "Phone/Memo, MP3 play, MP3 File Information and Environment" in a dropdown menu box 212.

In main menu 202, there are provided with two windows: a first window 214 showing directory information of computer 200 in a left side and a second window 216 showing file information of MP3 player 300 in a right side. There are provided with two move buttons over the windows 214 and 216: a first move button 218 for downloading a selected files from computer 200 to MP3 player 300 and a second move button 220 for uploading a file stored in MP3 player 300 to computer 200. If a user selects a file from first window 214 with a mouse pointer and then clicks first move button 218, the selected file is downloaded to MP3 player 300. To the contrary, in order to upload a file stored in MP3 player to computer, the user should select the file from second window 216 with the mouse pointer and then click the second move button 220.

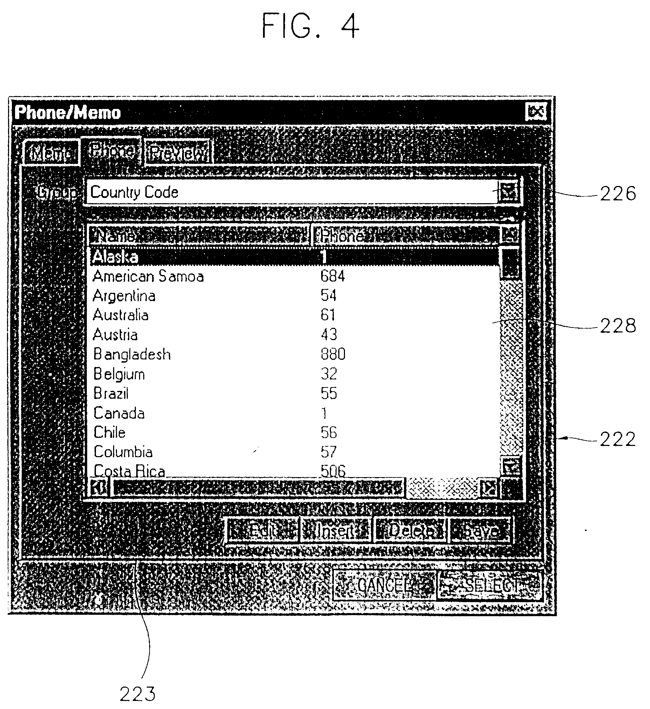

In response to a selection of the Phone/Memo menu of Tool menu 212, a Phone/Memo window 222 is displayed as shown in FIG. 4. There are provided with three menus such as "Memo, Phone, and Preview" and two buttons of "Cancel and Select". In response to a selection of the Phone menu, there is displayed a Phone menu window 223 having two input windows of "Group and Name and Phone Number" and four buttons of "Edit, Insert, Delete and Save". For a registration of a phone number, a user should choose a group in Group input window 226, input the phone number through Name and Phone Number window 228 and click save button. Besides, Phone menu window 223 has some other buttons for vertical and horizontal scroll, edit, insert, delete, and save.

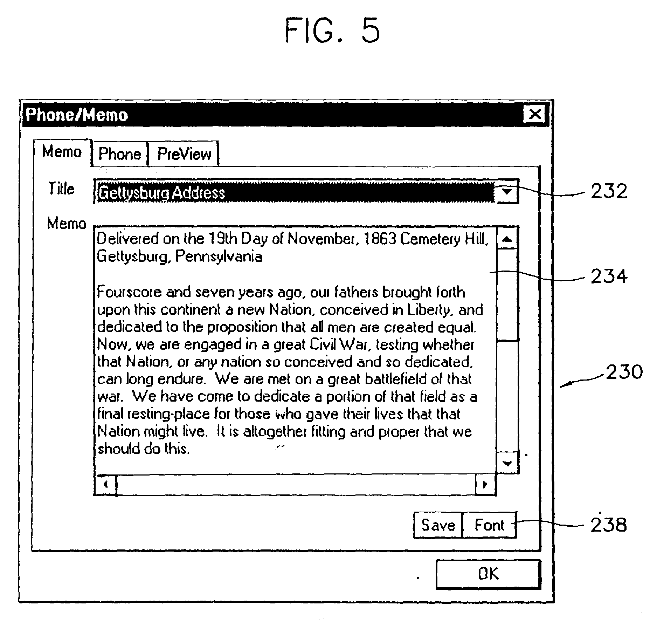

When the Memo menu is selected, a Memo window 230 is displayed as shown in FIG. 5. There are provided with a "Title" window 232, a "Memo" window 234, vertical ans horizontal scroll buttons, and save and font buttons 238 in Memo window 230. After the user sets a particular font face and size with the font button, the graphic character is displayed as a set in a display panel 330 of MP3 player.

The Preview menu allows the user to see the contents of display panel 330 of MP3 player through the monitor of computer 200.

Character data, except English character and numeric data, of additional information for a music file such as title, artist and genre, which are called ID3 tag information, phone numbers and memos are downloaded to MP3 player 300 in a form of a bit-map data for the display through display panel 330 of MP3 player 300. For this, computer 200 converts the character data of a file to be downloaded to MP3 player 300 into a bit-map data and loads them to a virtual image buffer. At this time, the record unit to the image buffer is dependent on the resolution of display panel 330 of MP3 player 300. For example, if display panel 330 is realized with the LCD panel, the record unit is 16x16 pixels. Especially, the ID3 tag information is also converted into a bit-map data which is added to the head of the MP3 music file and is downloaded in a MP3 file form to MP3 player 300. Furthermore, text codes of the phone numbers and memos are also converted into a bit-map data prior to the download to MP3 player.

As such, computer 200 is connected with MP3 player 300 through the parallel port and manages the data communication with MP3 player 300 for the download and upload of any kinds of computer files including the MP3 music file, the phone number file and the memo file with the management program.

Without mentioning that a phone number file or a memo file can be made with computer 200, such file can be made with MP3 player 300 if it has a data input means. As the phone number and memo data are managed in computer 200 and an initialization of the previous data of MP3 player 300 is performed prior to the transfer of data, a new version of the data is stored in MP3 player at every download of data.

MP3 player 300 has a voice recording function, which will be described below in detail, and a voice signal is encoded by PCM or ADPCM method prior to being stored as a voice file in MP3 player 300. The management program supports a wave driver function that enables uploading of the encoded voice file from MP3 player to computer 200 and transforming the voice file into a wave signal so as to output a voice through a sound card of computer 200. Furthermore, the management program has a function of compressing a music data of other formats other than MP3 format and of decompressing and decoding a compressed MP3 music file to reproduce music.

Meanwhile, referring to FIG. 1, MP3 player 300 includes an interfacing section 312, memory 314, a coder/decoder (CODEC) 316, an analog-to-to digital (A/D) convener 318, a digital-to-analog ( D/A) converter 320, an earphone jack 322, a line-out jack 323, a built-in type microphone 324, a line-in jack 325, an amplifier 326, a key pad 328, a display section (330), a power supplier 332, a DC adapter jack 334, a battery 336 and a controller 340.

Interfacing section 312 supports the data communication between computer 200 and MP3 player 300. Interfacing section 312 has a parallel port socket which is connected to the parallel port of computer 200 through a communication cable 400. An example of the parallel port socket is a personal computer memory card international association (PCMCIA) with 15 pins comprising a ground pin, 8-bits data pins and 6-bits control signal pins. The six control signals are as follows: strobe, ack, busy, auto-feed, initialize, select-in. Especially, the strobe signal, here, is used as a read signal and the auto-feed signal is used as a write signal. That is, interfacing section 312 supports a bidirectional data communication between computer 200 and MP3 player 300 in response to the six control signals.

For a voice recording, MP3 player 300 has line-in jack 325, built-in type microphone 324, amplifier 326 connected to microphone 324, and A/D converter 318 connected to line-in jack 325 and amplifier 326. An external microphone 600 can be connected to A/D converter 318. A voice source which transfers a voice signal through line-in jack 325 is not confined to microphone 600 and a conventional cassette tape recorder can be an example of the voice source. The voice signal provided from built-in microphone 324 or line-in jack 325 is amplified by amplifier 326. The amplified voice signal is converted into digital data by A/D converter 318 which is controlled by controller 340. The digital data is fed to CODEC 316.

Memory 314 works as a data storage of MP3 player which stores various kinds of computer files downloaded from computer 200 and voice files encoded by CODEC 316. It is required that memory 314 can sustain its data even in the state of power-off. Accordingly, a nonvolatile memory should be used as memory 314. In view of size and stability, a flash memory is strongly recommended.

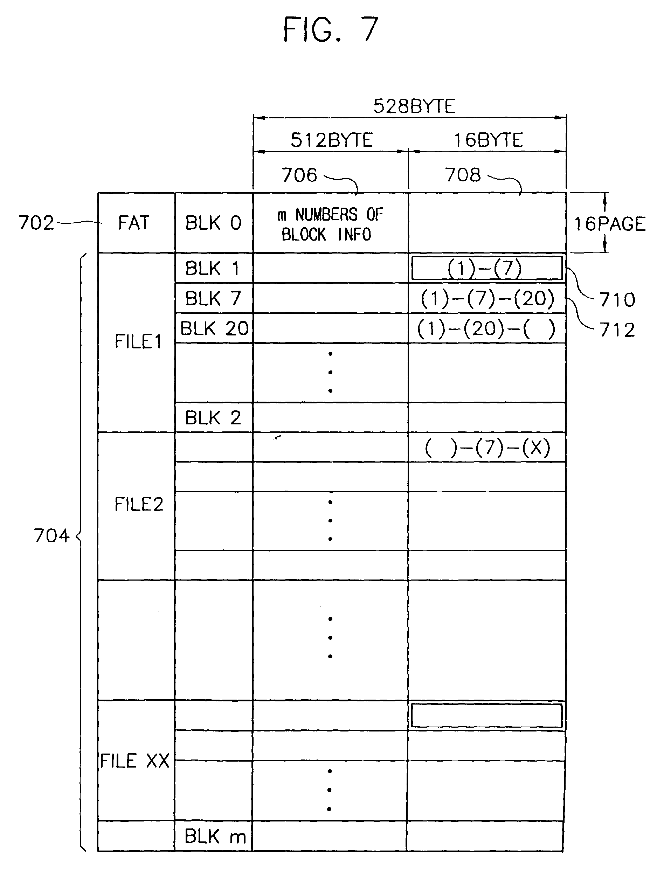

FIG. 7 illustrates a mapping format of memory 314. The memory map comprises an file allocation table (FAT) area 702 and a data area 704. A first block BLK0 is designated as FAT area and the other blocks BLK1 ∼ BLKm are designated as data area 704. One block includes a main area 706 with a dimension of 512 bytes by 16 pages and a sub area 708 with a dimension of 16 bytes by 16 pages.

In main area 706, block information of all the blocks is stored as shown in Table 1, and identification information of the flash memories is stored in sub area 708.

**〈Table 1〉**

| CODE | CONTENT |
|---|---|
| FF | blank block |
| 00 | bad block |
| CC | non-existent block |
| M | first block of the music file |
| m | music file block |
| T | first block of phone number file |
| t | phone number file block |
| D | first block of memo file |
| d | memo file block |
| P | first block of PCM file |
| p | PCM file block |
| E | first block of computer file (wp, txt, exe) |
| e | computer file block |

In data area 704, file information is stored. Every file consists of a plurality of blocks. In the first block of sub area 710 of every file, the file information of the corresponding file is stored. The file information includes a file type (a music file, a PCM file, a phone number file, a memo file and any other computer file), a block number of the file, a current block number, a next block number, an effective data size in the current block, a file size, a file name, and date and time. Sub area 712 of each block from the second block of every file contains block information of the corresponding block. The block information consists of a file type, a block offset, a previous block number, a current block number, a next block number, and an effective data size in a current block.

Accordingly, the file structure can be analyzed by referring the first block of each file in FAT area 702 and then by referring the file information in sub area 710 of the referred first block. Since the next block information is stored in the sub area of the current block (refer to 710 and 712) for the block linkage, the blocks of each file can be successively read out. Regarding file 1 in FIG. 7, it can be known from the information (1)-(7) in sub area 710 of the first block that the current block number is 1 and the next block number is 7. Furthermore, it can be known from the information (1)-(7)-(20) in sub are 712 that the current block number is 7, the previous block number being 1, the next block number being 20. Since the data of every file can be read out referring to the linkage information of all the blocks, the forward or backward reproducing operation can be easily and accurately performed.

CODEC 316 functions as a encoder together with a decoder. For the reproduction of a MP3 music file stored in memory 314, CODEC 316 decompresses the MP3 music file from controller 340 according to the MP3 format and decodes the decompressed music file into in an audio data in a bit stream form. Further, when CODEC 316 is provided with a digital voice data from A/D converter 318, CODEC 316 functions as an encoder which encodes the digital voice data by PCM or ADPCM method. The encoded data is stored in a file form in memory 314 by controller 340. Meanwhile, for the reproduction of the voice data file stored in memory 314 through earphone 500, CODEC 316 decodes the voice data file in a corresponding demodulation method into a bit stream form of the digital voice data which is provided to D/A converter 320. For the three optional functions, CODEC 316 has a read only memory (ROM) and a random access memory (RAM). A decoding program for the MP3 decoder function is stored in the ROM. Programs for decoding and encoding the voice signal are selectively loaded to the RAM by controller 340 when necessary. That function for CODEC 316 to perform is dependent on the program loaded by controller 340. If controller 340 does not direct a particular function, CODEC 316 functions as the MP3 decoder; otherwise, CODEC 316 performs the particular function of the encoder and decoder for the voice. For the control of the function of CODEC 316, controller 340 should designate the function of CODEC 316 based on the type of a file to be processed together with feeding and fetching the data in relation with CODEC 316 in a serial transmission method.

D/A converter 320 converts the decoded voice data provided from CODEC 316 into an analog voice signal to be transferred to earphone jack 322 or line-out jack 323 by the control of controller 340. Line-out jack 323 can be utilized as an output terminal for any other apparatus other than earphone 500.

In the meantime, MP3 player 300 has display section 330 for displaying characters or graphics. Display section 330 can be made with LCD panel, for example, which has an icon display window and a graphic dot display window with a dimension of 128 by 32 dots and a driver for the LCD panel. In the icon display window, there are provided several icons representing such as a battery indicator, a holder indicator for blocking unintended button operation, a play mode indicator, a genre indicator, a volume indicator, and an available memory size. In the graphic dot display window, information such as the title of a music, phone number and contents of a memo are displayed. The data of these kinds of information can be displayed simply in the form of a bit-map image in the display panel without any particular signal process because they are stored in memory 314 as a bit-map. Consequently, by means of the bit-map image method, all languages from the world can be displayed in LCD panel 330 so long as they can be expressed in computer 200.

Power supplier 332 includes at least a battery 336 and has a configuration for receiving an external power through DC adapter jack 334. Power supplier 332 provides operating voltages to every section of MP3 player and is controlled by controlled 340 to be automatically power-on or power-off.

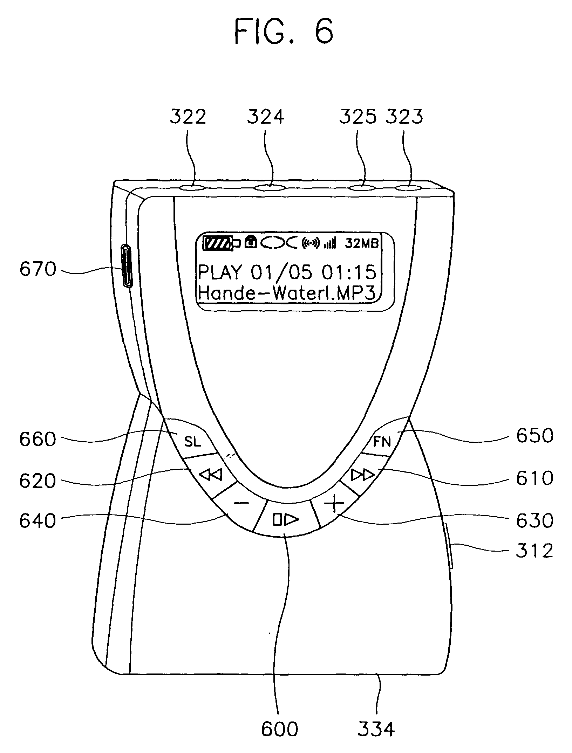

Meanwhile, FIG. 6 shows a perspective view of MP3 player 300. Line-in and line-out jack 325 and 323, built-in type microphone 324 and earphone jack 322 are arranged at the cop of a housing, and a parallel port socket of interface section 312 is disposed at the left side of the housing. In the front of the housing, a LCD panel and key pad 328 therebelow are disposed. Any other components are installed within the housing.

Key pad 328 includes seven keys such as a play/stop key 600, a forward key 610, a backward key 620, a up key 630, a down key 640, a function key 650 and a selection key 660 and a hold key 670 for preventing keys from being operated accidentally or being in contact unintended. Functions of every keys will be described later.

Controller 340 can be made with a microcomputer. The microcomputer may includes a CPU, a system RAM, a system ROM and an A/D converter on an one-chip. Controller 340, being connected to computer 200 through interface section 312, receives a selected file from computer 200 and stores it in memory 314. In addition, controller 340 loads a voice data encoded by CODEC 316 in a form of ADPCM file to memory 314. Controller 340 also performs, in response to the selection signals from key pad 328, a function of reading the voice data file or MP3 music file stored in memory 314 to be transferred to CODEC 316 and controlling the conversion of a read-out file into an audio output signal by controlling CODEC 316 and D/A converter 320. Particularly, controller 340 controls A/D converter 318 to sample an analog voice signal in a frequency of 8, 16 or 32 Mkz for converting it into the digital data, and controls CODEC 316 to compress the digital data into one fourth and to convert the compressed data into PCM or ADPCM data file.

Furthermore, when the key selection signal from key pad 328 directs the output of character information, controller 340 reads a related file from memory 314 and controls the display of the related file on display section 330. Controller 340 is only comprised of font data, for example the English character font and the numeric font, necessary for the operation of MP3 player and for the message output. This can downsize a font ROM to be provided in controller 340. Although controller 340 contains a minimum size of font data, it can support the display of all languages because the character data to be displayed through display section 330 is a bit-map data. In other words, even if a file concerning character data is in other languages other than English, there is no need of such font data so long as the file can be converted into a bit-map data. Therefore, MP3 player 300 can display all languages so long as such language is supportable in computer 200.

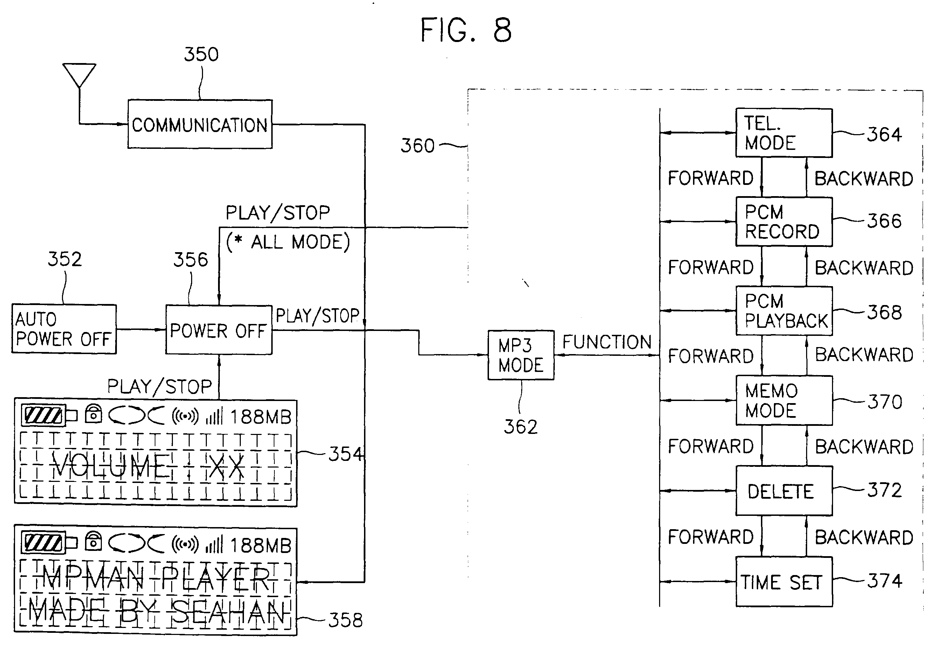

FIG. 8 shows a configuration of operating modes of MP3 player 300. There are provided various operation modes: a communication mode 350, an auto power-off mode 352, a volume control mode 354 and a function mode 360. Function mode 360 includes six function modes: an MP3 mode 362 which is a main function mode for the control of play/stop of a MP3 music file, a phone mode 364, a voice record (PCM) mode 366, a voice playback 368, a memo display mode 370, a file delete mode 372, and a time set mode 374. Transition between MP3 mode 362 and one of six function modes 364 ∼ 374 is performed with function key 650, and the transition between the six function modes 364-374 is performed with forward key 610 and backward key 620.

If auto power-off mode 352 is set or play/stop key 600 is selected over a predetermined time, for example 3 seconds during volume control mode 354 or function mode 360, power-off mode 356 is enabled to shut off the power supply. And, if any key is selected during power-off mode 356 or communication mode 350 is performed, an initial window display mode 358 is enabled and a predetermined message is displayed in the LCD panel of display section 330.

Hereinafter, the function modes are described in detail.

### 1. MP3 Mode

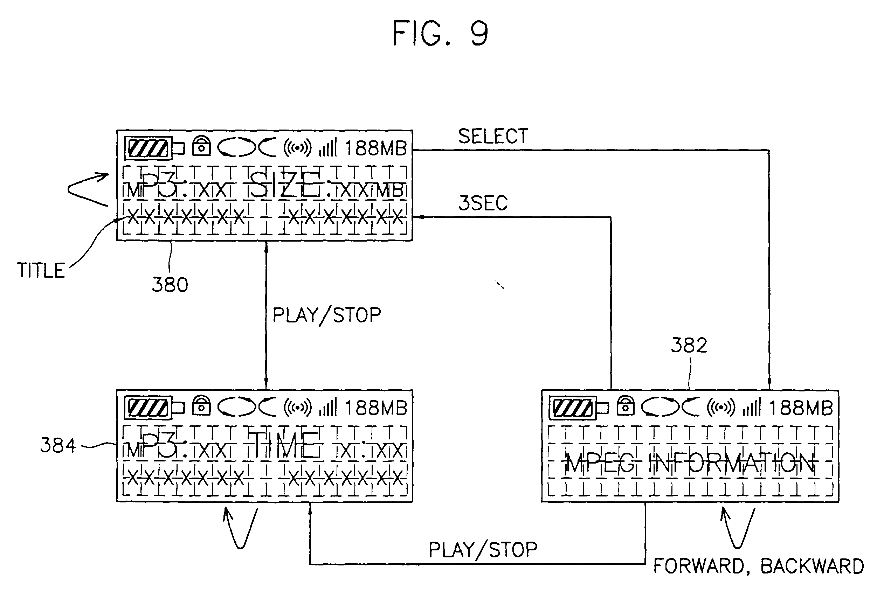

This mode is the main mode for operating a MP3 music file. Referring to FIG. 9, when the power is turned on, there is displayed information of music file such as a music number, a file size and a title of music which was played prior to the power-off (380) in displaying section 300. In response to a signal of select key 660 during a stop mode in which no MP3 music file is played, an ID3 tag information such as the title, artist and genre of a MP3 music file is displayed (382). If a user selects a file with forward or backward keys 610 or 620 and pressing play/stop key 600, information such as the music number, title and play time of currently playing MP3 music file is displayed. It is allowable to select in addition to a forward play mode or a backward play mode, a fast forward play mode or a fast backward play mode during a play mode. Pressing play/stop key 600 during the play mode stops the play of the music file and activates initial display 380 together with saving the displayed data. At every pressing of select key 600 in the play mode, following modes are sequentially selected: a normal mode for playing all MP3 files and stopping, a repeat mode for repeating the current MP3 file, a repeat all mode for looping all MP3 files, a shuffle mode for playing randomly MP3 files once, a shuffle repeat all mode for playing randomly and repeating all songs. A genre can be changed by pressing function key 650 in the play mode. The types of genre are as follows: normal (no sound effect applied), classic, disco, jazz, pop and rock.

### 2. Function Mode Selection

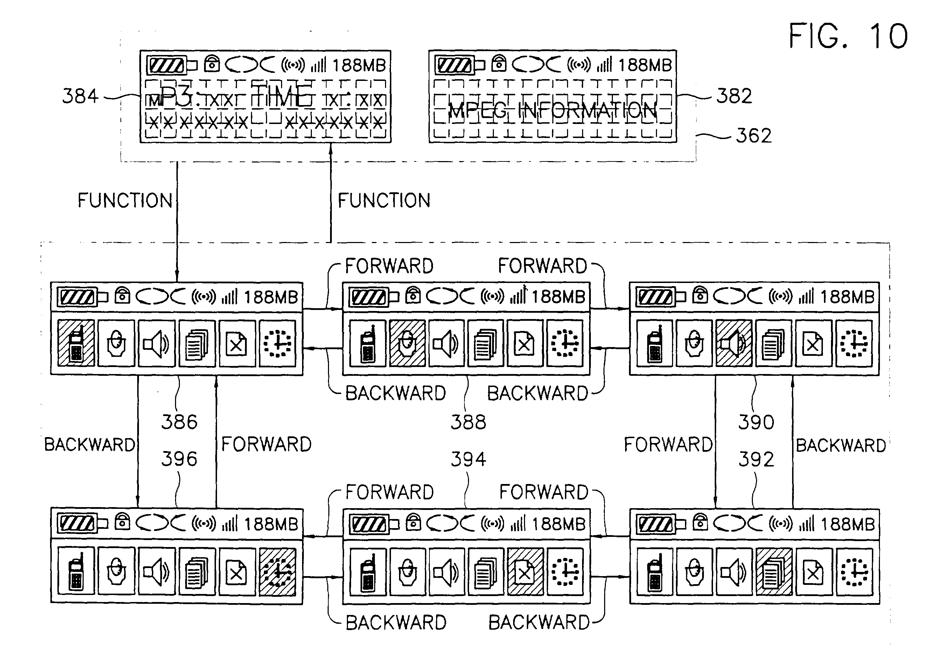

Referring to FIG. 10, if function key 650 is selected in the play mode (382 or 384), six icons for various utilities are displayed on the LCD panel of display section 330 (386): phone menu 364 for browsing phone groups and their contents; voice record menu 366 for recording voice in PCM (or ADPCM ) file; voice playback menu 368 for playing the recorded PCM files; memo menu 370 for browsing memo titles and their contents; delete menu 372 for deleting unnecessary files including MP3 files, PCM files and memo titles; and time set menu 374 for setting the time. At first, a cursor can be shifted to an adjacent icon by forward key 610 and backward key 620. In order to select a function mode, a user should presses select key 660 after locating the cursor on a desired icon.

### 3. Phone Menu

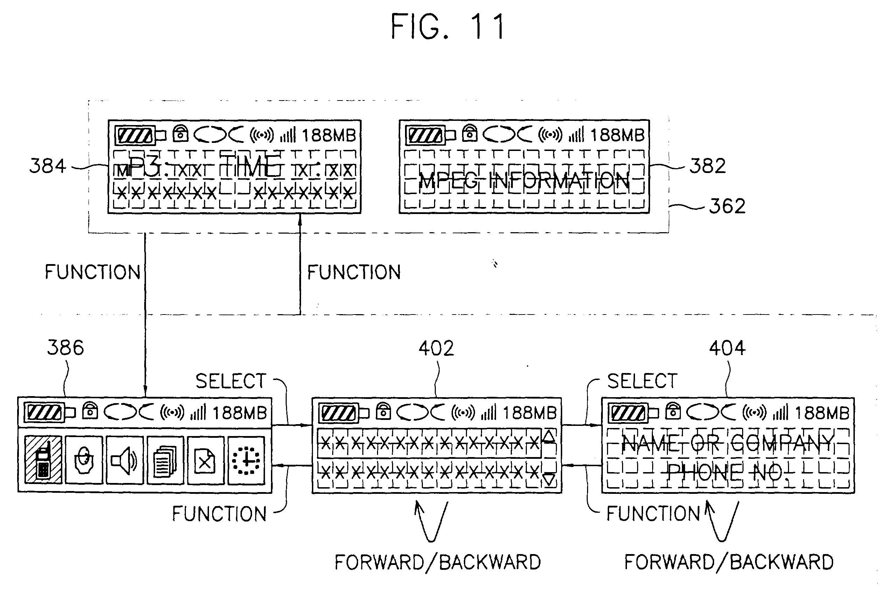

In FIG. 11, a phone groups downloaded from computer 200 to MP3 player are listed by pressing select key 660 in phone menu 660 (402). In this state, a desired group is selected with select key 660 while scrolling the groups with forward and backward keys 610 and 620. Then a user will see the name and phone numbers in each phone group displayed on the LCD panel (404). The scroll of the phone numbers is also performed with forward and backward keys 610 and 620 and the return of the previous view is performed with function key 650.

### 4. Voice Record Menu

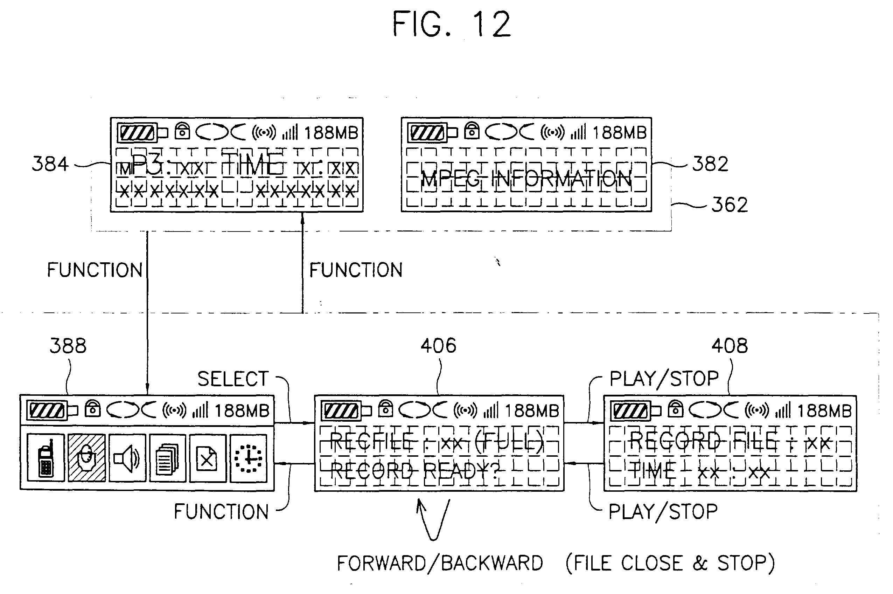

Referring to FIG. 12, in response to selecting the voice record icon, the file number and other information of a file to be recorded are displayed (406). If a user selects a new file or an available recorded file with forward and backward keys 610 and 620, the file number and recording time of the selected file are displayed. And, the user can select a record quality with select key 660 in a voice record standby mode 406. If the user presses play/stop key 600 in order to record the voice, a PCM data of a voice originated from microphone 324 and line-in jack 325 is appended to the end of an available file or is recorded in a new file (408). To stop the recording, play/stop key 600 should be pressed again.

### 5. Voice Playback Menu

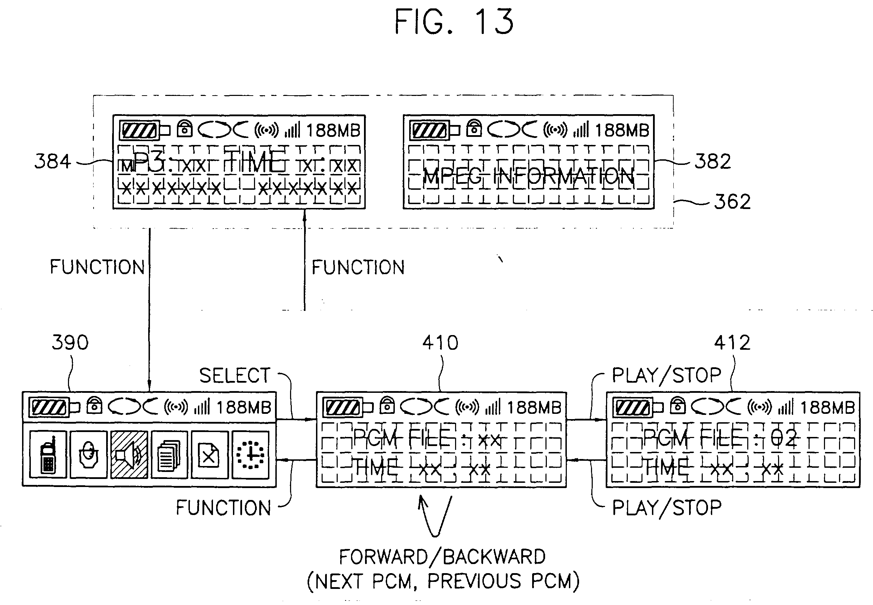

Referring to FIG. 13, selecting the icon of this menu 390 displays a PCM file number and a playback time (410). In this state, a user can select a PCM file in be played by scrolling the PCM file number with forward and backward keys 610 and 620. If the user presses play/stop key 600 after file selection, a PCM data is reproduced into an original voice together with displaying the selected PCM file number and the playback time (412).

### 6. Memo Menu

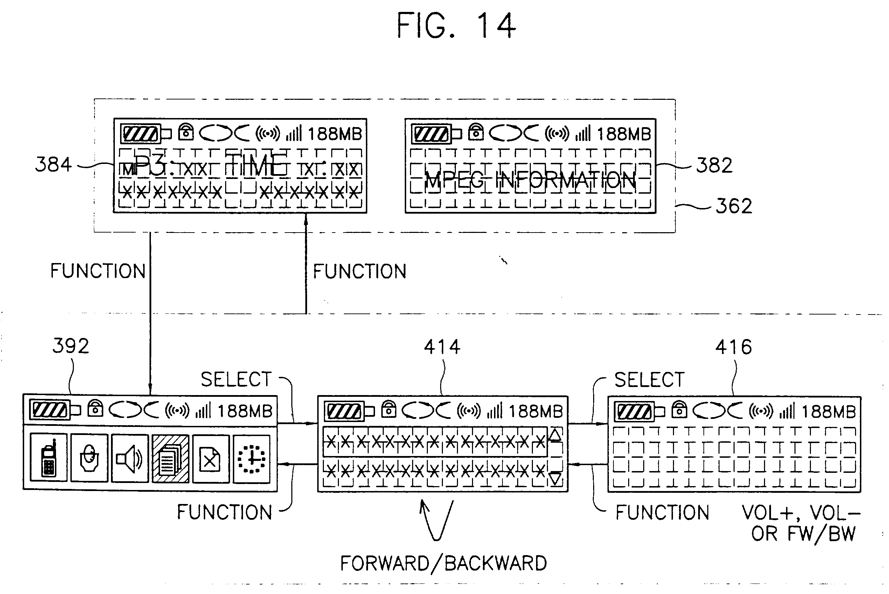

Referring to FIG. 14, selecting the icon of this menu 392 displays a memo title (414). In this state, if a user selects a memo information with forward and backward keys 610 and 620 and presses select key 660, the contents of the memo is displayed. The contents of the memo can be scrolled with up and down keys 630 and 640 or forward and backward keys 610 and 620.

### 7. Delete Menu

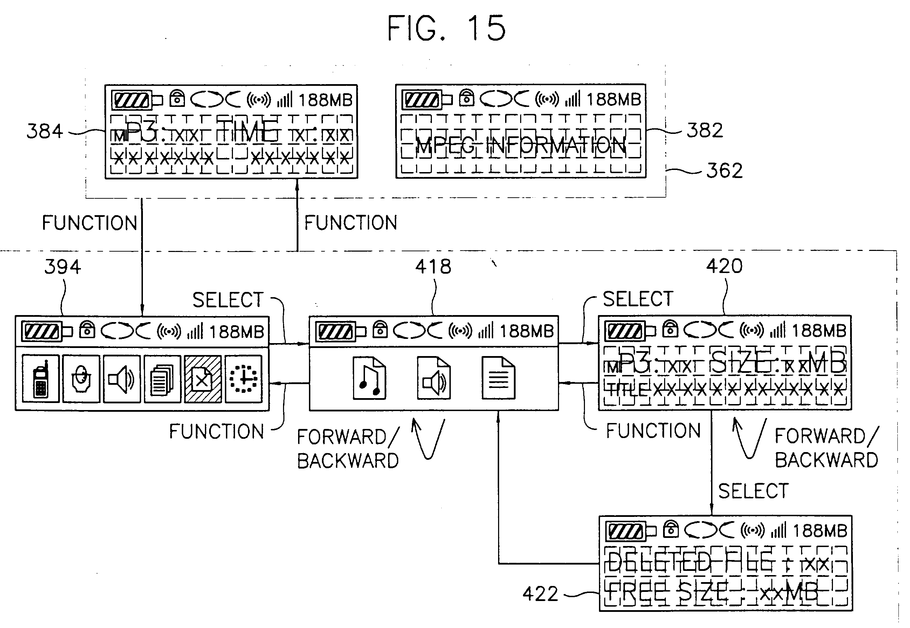

Referring to FIG. 15, selecting the icon of delete menu 394 displays three icons corresponding to a MP3 music file, a PCM file and a memo file (418). In this state, if a user presses select key 660 after selecting one from these three types of files with forward and backward keys 610 and 620, the file number, size and title of the selected file are displayed (420). In order to delete a file, the user should press select key 660 after selecting a file to be deleted with scrolling the stored files with forward and backward keys 610 and 620. In response to the file deletion, the deleted file number and the available memory size are displayed and then the view of step 418 is displayed.

### 8. Time Set Menu

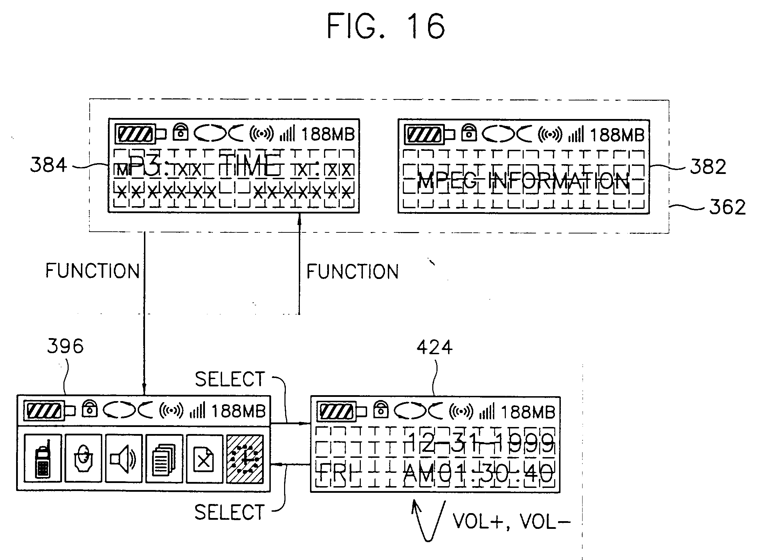

Referring to FIG. 16, selecting the icon of time set menu 394 displays the current date and time (424). In this state, a user can go into the time set mode with select key 660. Move to an item to be set can be done with forward and backward keys 610 and 620, and change of data can be adjusted with up and down keys 630 and 640. In order to save the changed value, the user should press select key 660.

As described above, a user can select a MP3 music file or a PCM voice file to be selected from memory 314 with suitable key operations and various function keys of key pad 328 and can further direct to display phone numbers and memos stored in memory 314 on the LCD panel. In addition, the user can record voices originated from microphones 324 and 600 by enabling a voice recording function. Operations of key pad 328 is acknowledged by controller 340 which reads periodically output terminals of key pad 328. And, controller 340 controls corresponding elements to perform directed functions by providing suitable control signals based on the analyzed direction from key pad 328.

While the present invention has been particularly shown and described with reference to particular embodiments thereof, it will be understood by those skilled in the art that various changes in form and details may be effected therein without departing from the spirit and scope of the invention as defined by the appended claims.

## Claims

1. A method of recording and reproducing a digital data, comprising the steps of:
a) executing in a data providing apparatus a management program for integrally managing both a data providing apparatus and a portable data recording/reproducing apparatus;
b) selecting a file to be downloaded to the portable data recording/reproducing apparatus from files stored in the data providing apparatus in a running state of the management program;
c) storing the downloaded file in a nonvolatile memory of the portable data recording/reproducing apparatus;
d) recording a voice signal from a microphone in a form of a digital voice file in the nonvolatile memory;
e) selecting a file to be reproduced from the files stored in the nonvolatile memory; and
f) reproducing the selected file into an audio output by decoding the selected file.

2. The method as claimed in claim 1, wherein a MP3 music file downloaded from the data providing apparatus includes a music data and an additional data, and the additional data is downloaded in a form of bit-map and is displayed on a display panel of the portable data recording/reproducing apparatus when the MP3 music file is reproduced.

3. The method as claimed in claim 1, further comprising the step of selecting a file from the nonvolatile memory and uploading the selected file.

4. The method as claimed in claim 1, further comprising the steps of: inputting predetermined information via an input means of the data providing apparatus in a running stare of the management program; downloading the information in a form of bit-map to the portable data recording/reproducing apparatus; storing the downloaded information in the nonvolatile memory; and displaying the information stored in the nonvolatile memory on a display panel of the portable data recording/reproducing apparatus.

5. The method as claimed in claim 4, wherein the predetermined information includes a data comprising phone number and/or memo.

6. The method as claimed in claim 5, wherein the data comprising the phone number includes at least a group and the group includes at least a phone number and a name.

7. The method as claimed in claim 5, wherein the data comprising the memo includes a file name and a memo string.

8. The method as claimed in claim 4, further comprising the step of updating the predetermined information by using functions of editing, deleting and inserting.

9. The method as claimed in claim 4, further comprising the step of displaying the predetermined information on a monitor of the data providing apparatus in a form corresponding to a display format of the portable data recording/reproducing apparatus.

10. The method as claimed in claim 1, wherein the step d) includes the steps of: displaying recording file names on a display panel of the portable data recording/reproducing apparatus in response to a selection of voice recording mode; selecting an available file name from the displayed recording file names; transforming the voice signal from the microphone into an analog voice signal; converting the analog voice signal into a digital voice data; encoding the digital voice data by a pulse coded modulation method or an adaptive differential pulse coded modulation method; and storing the encoded voice data in the nonvolatile memory in a selected file name.

11. The method as claimed in claim 1, wherein the step f) includes the steps of: displaying file names on a display panel of the portable data recording/reproducing apparatus in response to a selection of voice reproducing mode; selecting a file from the displayed file names; reading the selected file from the nonvolatile memory; and decoding data of the read file by the predetermined method to output an analog audio signal for the audio output.

12. The method as claimed in claim 1, wherein the data providing apparatus is a computer and/or a data vending machine.

13. A portable data recording/reproducing apparatus, comprising:
an analog-to-digital converting means for converting an analog audio signal of a voice provided by a microphone into a digital audio signal;
a coding/decoding means for decoding an MP3 music file by MP3 decoding method, encoding the digital audio signal into a voice data file by a predetermined encoding method, and decoding the voice data file by a predetermined decoding method;
an interfacing means for interfacing download and upload of a data file between an external data providing apparatus and the portable data recording/reproducing apparatus;
an nonvolatile memory means for storing the encoded voice data file from the coding/decoding means and the data file from the data providing means at a designated address;
a key input means, including a plurality of function selection keys, for selecting a file to be reproduced into an audio signal from the nonvolatile memory and for directing a predetermined function with a function selection keys;
a digital-to-analog converting means for converting a digital audio signal decoded by the coding/decoding means into an analog audio signal for an audio reproduction; and
a control means, in response to an output signal of the key input means, for controlling a data communication between the data providing apparatus and the data recording/reproducing apparatus, reading and writing operations to the nonvolatile memory and a reproduction of a read-out file.

14. The apparatus as claimed in claim 13, further comprising a displaying means for displaying character data corresponding to the selected file by the key input means on a display panel.

15. The apparatus as claimed in claim 13, wherein the analog-to-digital convening means includes a built-in type microphone; a line-in jack; an amplifier for amplifying the analog audio signal from the microphone; and an analog-to-digital converter for converting the analog audio signal from the amplifier or the line-in jack into the digital audio signal.

16. The apparatus as claimed in claim 13, wherein the character data of the data providing apparatus is downloaded in a bit-map format.

17. The apparatus as claimed in claim 13, wherein the data file includes at least one of the MP3 music file, a phone number file and a memo file.

18. The apparatus as claimed in claim 13, wherein the voice data file is encoded either in a pulse coded modulation method or an adaptive differential pulse coded modulation.

19. The apparatus as claimed in claim 13, wherein the data providing apparatus is a computer and/or a data vending machine.

20. A system for recording and reproducing a digital data, comprising:
a computer, provided with an MP3 file management program, for performing download and upload of any kinds of computer files besides an MP3 music file and a recorded voice file through a parallel port; and
an MP3 player for reproducing the MP3 music file while displaying information corresponding to the MP3 music file, for recording a voice signal originated from a microphone in a form of digital voice file in an nonvolatile memory and reproducing the digital voice file if necessary, and for displaying information of phone numbers and memos, in response to user's key operations, wherein the MP3 player is connected to the computer through the parallel port, the MP3 music file and the information of the phone numbers and memos are downloaded from the computer to be stored in the nonvolatile memory.

21. The apparatus as claimed in claim 20, wherein the computer downloads the MP3 music file through Internet or a computer communication network.
